# EUROPEAN PATENT APPLICATION

(11) **EP 2 743 918 A1**
(43) Date of publication of application: **18.06.2014**
(21) Application number: 13164432.0
(22) Date of filing: 19.04.2013
(51) Int. Cl.: G10K 9/22, C22C 21/06

(54) **Transducer case**

(30) Priority: 12.12.2012 TW 101146888; 12.12.2012 TW 101224071
(71) Applicant: Tung Thih Electronic Co., Ltd., 33852 Luchu, Taoyuan County (TW)
(72) Inventor: Lee, Shih-Feng, 33852 Taoyuan County (TW); Tsai, Tzu-Chin, 33852 Taoyuan County (TW)
(74) Representative: Kierdorf Ritschel

(57) **Abstract**

A case for disposing a piezoelectric member (3) includes a case body (1) having a top surface (11) and is defined with a central cavity (12) extending from the top surface (11) into the case body (1) for receiving the piezoelectric member (3), wherein the case body (1) is made of an alloy containing Al, Mg, Fe, Si, Cu, Zn, Mn, and Cr.

## Description

The invention relates to a case of a transducer, more particularly to a case of an ultrasonic transducer.

In U.S. patent No. 7737609, there is disclosed a conventional ultrasonic sensor for a vehicle which has an outer case that is made of aluminum. The conventional aluminum case has a yield strength of 3.5 Kg/mm², a tensile strength of 9 Kg/mm², a shear strength of 6.5 Kg/mm², a fatigue strength of 3.5 Kg/mm², and an elongation rate of 45%. However, such intrinsic mechanical properties of the aluminum case limit the electrical-to-mechanical energy transfer thereof and result in residual vibration that adversely affects the efficiency of the ultrasonic sensor.

On the other hand, the conventional case of the ultrasonic transducer for a vehicle is usually painted on an outer surface thereof for decoration. However, due to surface smoothness of the case, it is difficult to prevent a paint layer of the case from flaking off or being chipped off after a long period of working time. U.S. patent application publication No. 2012/0113758A1 discloses a case of an ultrasonic transducer which has a case body provided with a transparent coating thereon for improving the adhesive property of the paint layer. However, such coating requires a wet chemical pre-treatment for the outer surface of the case body and consumes massive chemical reagents which can cause environmental pollution.

Therefore, the object of the present invention is to provide a case having relatively high electric-to-mechanical energy transfer efficiency and low residual vibration effect.

Accordingly, a case of the present invention for disposing a piezoelectric member of an ultrasonic transducer includes a case body having a top surface and being defined with a central cavity extending from the top surface into the case body for receiving the piezoelectric member, wherein the case body is made of an alloy containing Al, Mg, Fe, Si, Cu, Zn, Mn, and Cr.

Preferably, the alloy contains 4.5 to 6 wt% of Mg, 0.4 wt% of Fe, 0.3 wt% of Si, 0.1 wt% of Cu, 0.1 wt% of Zn, 0.05 to 0.2 wt% of Mn, and 0.05 to 0.2 wt% of Cr with the remainder being Al.

The case of this invention has a yield strength of 35 Kg/mm², a tensile strength of 42 Kg/mm², a shear strength of 22.5 Kg/mm², a fatigue strength of 15.5 Kg/mm², and an elongation rate of 15%.

Preferably, the case body of the case further includes a positioning projection extending radially and outwardly from a top end of the case body.

Preferably, the case body is further defined with a pin hole extending from the top surface into the case body.

Preferably, the case body further has an outer surface connected to the top surface, the outer surface having an average roughness (Ra) ranging from 0.9 µm to 1.6 µm.

Other features and advantages of the present invention will become apparent in the following detailed description of the preferred embodiment with reference to the accompanying drawings, of which:
Figure 1 is a perspective view of a preferred embodiment of a case according to the invention, in which a piezoelectric member is disposed;
Figure 2 is a top view of the preferred embodiment;
   and
Figure 3 is a sectional view of the preferred embodiment taken along line III-III of Figure 2, in which a positioning projection of the case is engaged to an engaging groove of a positioning unit.

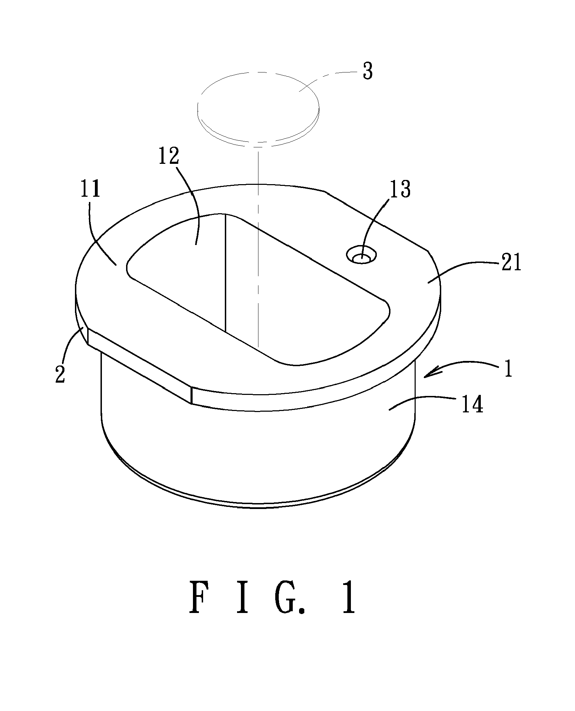

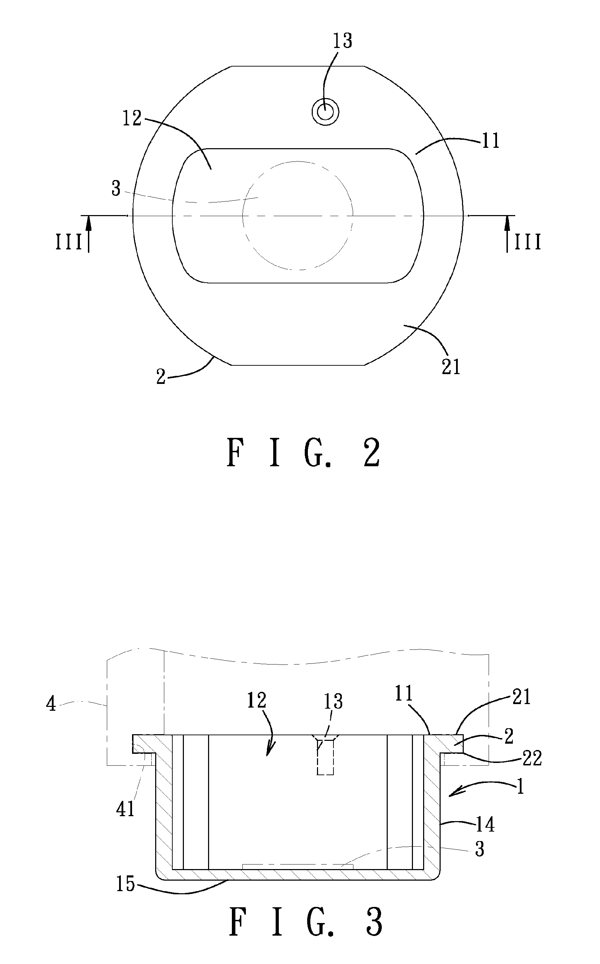

Figures 1, 2, and 3 show a preferred embodiment of a case according to the present invention which is used for disposing a piezoelectric member 3 of an ultrasonic transducer and which includes a case body 1 and a positioning projection 2.

The case body 1 has a top surface 11 and an outer surface including a bottom surface region 15 and a surrounding surface region 14 interconnecting the top surface 11 and the bottom surface region 15. The case body 1 defines a central cavity 12 that extends from the top surface 11 into the case body 1 for receiving the piezoelectric member 3. The case body 1 further defines a pin hole 13 for inserting a pin (not shown) so that the pin is capable of electrically connecting to the piezoelectric member 3 through the case body 1 for saving time of the assembling procedure for the ultrasonic transducer. The pin hole 13 extends from the top surface 11 into the case body 1 and is separated from the central cavity 12.

The positioning projection 2 is formed to extend radially and outwardly from a top end of the case body 1. In this embodiment, the positioning projection 2 has a top surface 21 flush with the top surface 11 of the case body 1, and an outer surface connected to the top surface 21 of the positioning projection 2 and the surrounding surface region 14 of the case body 1. The positioning projection 2 is adapted for engaging with an engaging groove 41 of a positioning unit 4 when assembling the ultrasonic transducer.

The case body 1 is made of an alloy containing 4.5 to 6 wt% of Mg, 0.4 wt% of Fe, 0.3 wt% of Si, 0.1 wt% of Cu, 0.1 wt% of Zn, 0.05 to 0.2 wt% of Mn, and 0.05 to 0.2 wt% of Cr with the remainder being Al, so that the case of the present invention has improved properties , i.e., a yield strength of 35 Kg/mm², a tensile strength of 42 Kg/mm², a shear strength of 22.5 Kg/mm², a fatigue strength of 15.5 Kg/mm², and an elongation rate of 15%. Such improvement in mechanical properties of the case according to the present invention increases the electric-to-mechanical energy transfer and effectively diminishes the residual vibration effect.

The outer surface of the case body 1 and the outer surface of the positioning projection 2 are impacted by high speed solid micro-particles, such as silicon, glass, or iron beads, to adjust the average roughness (Ra) thereof to range from 0.9 µm to 1.6 µm, so as to enable a paint layer tightly to adhere thereon while painting.

To sum up, the case according to the present invention made of the specific alloy has high electric-to-mechanical energy transfer efficiency and low residual vibration effect. Moreover, the positioning projection 2 of the case securely engages the engaging groove 41 so that the case of the present invention is capable of being securely positioned with the positioning unit 4. Furthermore, the outer surface of the case is processed to have the average roughness (RA) ranging from 0.9 µm to 1.6 µm, so as to allow the paint layer to tightly adhere to the outer surface of the case.

## Claims

1. A case adapted for disposing a piezoelectric member (3), said case including a case body (1) having a top surface (11) and being defined with a central cavity (12) extending from said top surface (11) into said case body (1) for receiving the piezoelectric member (3),
**characterized in that** said case body (1) is made of an alloy containing Al, Mg, Fe, Si, Cu, Zn, Mn, and Cr.

2. The case as claimed in claim 1, further **characterized in that** said alloy contains 4.5 to 6 wt% of Mg, 0.4 wt% of Fe, 0.3 wt% of Si, 0.1 wt% of Cu, 0.1 wt% of Zn, 0.05 to 0.2 wt% of Mn, and 0.05 to 0.2 wt% of Cr with the remainder being Al.

3. The case as claimed in one of claims 1 and 2, further **characterized in that** the case has a yield strength of 35 Kg/mm², a tensile strength of 42 Kg/mm², a shear strength of 22.5 Kg/mm², a fatigue strength of 15.5 Kg/mm², and an elongation rate of 15%.

4. The case as claimed in any one of claims 1 to 3, further **characterized by** a positioning projection (2) extending radially and outwardly from a top end of said case body (1).

5. The case as claimed in any one of claims 1 to 4, further **characterized in that** said case body (1) is further defined with a pin hole (13) extending from said top surface (11) into said case body (1).

6. The case as claimed in any one of claims 1 to 5, further **characterized in that** said case body (1) further has an outer surface (14) connected to said top surface (11), said outer surface (14) having an average roughness (Ra) ranging from 0.9 µm to 1.6 µm.
